Europäisches Patentamt

European Patent Office

Office européen des brevets

(19)

(11) **EP 1 598 935 A2**

(12) **EUROPÄISCHE PATENTANMELDUNG**

(43) Veröffentlichungstag:
    **23.11.2005 Patentblatt 2005/47**

(51) Int Cl.7: **H03H 21/00**

(21) Anmeldenummer: **05009412.7**

(22) Anmeldetag: **29.04.2005**

(84) Benannte Vertragsstaaten:
    **AT BE BG CH CY CZ DE DK EE ES FI FR GB GR
    HU IE IS IT LI LT LU MC NL PL PT RO SE SI SK TR**
    Benannte Erstreckungsstaaten:
    **AL BA HR LV MK YU**

(30) Priorität: **21.05.2004 DE 102004025471**

(71) Anmelder: **Micronas GmbH
    79108 Freiburg (DE)**

(72) Erfinder: **Van Klinken, Arnond Hendrik
    6874 BE Wolfheze (NL)**

(74) Vertreter: **Göhring, Robert
    Westphal - Mussgnug & Partner
    Patentanwälte
    Am Riettor 5
    78048 Villingen-Schwenningen (DE)**

(54) **Verfahren bzw. adaptives Filter zum Verarbeiten einer Folge aus Eingabe-Daten eines Funksystems**

(57)    Die Erfindung bezieht sich auf ein Verfahren zum Verarbeiten einer Folge aus Eingabe-Daten (x) eines Funksystems (DVB-T) mit einer adaptiven Filterung, wobei die Eingabe-Daten (x) einer ersten Vorhersagefilterung (BLP[]) zugeführt und damit gefiltert werden, die Eingabe-Daten (x) zeitlich um eine erste Verzögerung ($z^{-n+1}$) verzögert einer zweiten Vorhersagefilterung (FLP[n] zugeführt und damit gefiltert werden, wobei die eine der ersten und der zweiten Vorhersagefilterung rückwärts gerichtet und die andere vorwärts gerichtet durchgeführt wird, und die von der ersten und der zweiten Vorhersagefilterung (BLP[n], FLP[n]) gefilterten Daten zu auszugebenden Daten (y) addiert werden. Ein solches Verfahren wird in einem besonders bevorzugten adaptiven Filter vorteilhaft ausgeführt und dient bevorzugt zum Filtern eines digitalen OFDM-Fernsehsignals (DVB-T).

Fig. 1

EP 1 598 935 A2

**Beschreibung**

Die Erfindung bezieht sich auf ein Verfahren zum Verarbeiten einer Folge aus Eingabe-Daten eines Funksystems mit einem adaptiven Filter bzw. auf ein adaptives Filter zum Verarbeiten einer solchen Folge aus Eingabe-Daten eines Funksystems unter Verwendung einer Vorhersagefilterung.

Beispielsweise im Bereich der Übertragung von Signalen für ein digitales Fernsehsystem werden Daten verschiedener Folgen aus Daten einzelnen Kanälen zugeordnet. Jedem Kanal ist eine Übertragungsfrequenz bzw. ein Übertragungsfrequenzband zugeordnet. Durch die Knappheit der Ressource Frequenz werden die einzelnen Kanäle eng aneinander gelegt, was zu Signalüberlagerungen oder Überlagerungen von Signalkomponenten, insbesondere den Folgen aus Eingabe-Daten bei einem Empfänger führt. Probleme entstehen insbesondere hinsichtlich eines effizienten Einsatzes eines linear-phasigen adaptiven Filters bzw. Filterverfahrens für statische Daten, welche mit weißem Rauschen überlagert sind. Bisherige Filter bzw. Filterverfahren zum Verarbeiten von Daten bzw. Signalen mit multiplen sinusoiden Signalkomponenten statischer oder sich langsam ändernder Frequenz in einer Umgebung mit weißem Rauschen bieten derzeit keine befriedigenden Ergebnisse. Dies gilt insbesondere für die Anwendung im Bereich eines adaptiven Kompensationsfilters, welches als "Adaptive Line Enhancer" bekannt ist, bei der Kanalschätzung pilotbasierter OFDM-Systeme (OFDM: Orthogonal Frequency Division Multiplex).

Allgemein wird das Problem zum Unterdrükken von Rauschen auf sinusoiden Messdaten ohne Kenntnis von deren Inhalt oder Frequenzverteilung durch eine Form der Vorhersage durchgeführt. Üblicherweise wird eine adaptive lineare Vorhersage für diesen Zweck mit Hilfe eines adaptiven Filters bzw. Adaptive Line Enhancers (ALE) durchgeführt. Die meisten solcher adaptiven Filter werden zum Verbessern eines einzelnen engbandigen Signals in breitbandigem Rauschen verwendet. Bekannt sind aber auch adaptive Filter zum Verbessern multipel mehrfach überlagerter engbandiger Signale.

Zum Entfernen des Rauschen verwenden diese adaptiven Filter reine vorwärts gerichtete Vorhersageeinrichtungen bzw. Vorhersagefilter (FLP: Forward Linear Predictor). Bei all diesen werden stets deren Abgriffe (englisch Taps) bzw. Parameter individuell eingestellt und optimiert. Sowohl solche vorwärts gerichteten Vorhersagefilter als auch rückwärts gerichtete Vorhersagefilter (BLP: Backward Linear Predictor) haben den Nachteil, dass diese keine Linearität der Phase garantieren können. Sie entwickeln im Allgemeinen minimalphasige oder maximalphasige Abgriffsatz- (Tapset) Lösungen. Deren Vorhersagefehler wird dabei minimiert. Dabei wird das Kriterium des minimalen "Wiener Hopf"-Fehlers erreicht, was bedeutet, dass wichtige Teile der entwickelten Antwort bzw. der verbesserten Spektrallinien sich linear in-phasig verhalten, wenn ein Vergleich mit dem Originalsignal, d. h. dem Eingangssignal durchgeführt wird.

Grundlagen sind beschrieben in "Simon Haykin, Adaptive Filter Theory, 4. Auflage, 2002, Prentice Hall, Kapitel 3 (Linear Prediction), Abschnitt 5.3 (ALE's)" und in "Interference Suppression In Spread Spectrum Code Division Multiple Access Communications, (Rusch, L. A.), 1994, Dep. Electrical Engineering, Princeton University", wobei bei letzterem als Systemsausgangswerte nicht eine Vorhersage selber sondern der Fehler einer Vorhersage ausgegeben wird, um eine Interferenz zu detektieren, nicht aber um ein Signal zu detektieren.

Allgemein bekannt sind derartige adaptive Filter aus EP 1334554 und US 2002191688. Letzteres bezieht sich auf ein Gitter-Vorhersagefilter, welches durch eine Rauschsubtraktion mit Hilfe eines Kerbfilters implementiert wird.

Bekannt ist auch eine Vielzahl von Fachartikel zu dieser Problematik. "Adaptive Enhancement of Multiple Sinusoids in Uncorrelated Noise, Zeidler J. R., et. al., 1978, IEEE Trans. Acous. Speech Signal Process, Vol. ASSP-26, pp. 240 - 254" bezieht sich auf vorwärts gerichtete adaptive Vorhersagefilter als allgemeiner Übersichtsartikel. Zwei-seitige Wiener-Filter sind beschrieben in "Performance Analysis of LMS Adaptive Prediction Filters, Zeidler, J. R., 1990, Proc. IEEE, Vol. 78, pp. 1781 - 1806".

Bekannt ist die Verwendung von zwei gekoppelten Vorhersageeinrichtungen, welche gedoppelt und vorwärts kaskaden-artig aufgebaut sind, wobei der abhängige bzw. Slave-Vorfilter letztendlich zu einer IIR-Lösung zusammenführt, was für endliche Datensätze sehr unkomfortabel, aber effektiv für einzelne und sich langsam hinsichtlich der Frequenz ändernde sinusoide kontinuierliche Frequenznachführungen ist aus "Adaptive Line Enhancer with Self Tuning Prefilter, Coi, Y. S., Shin, H.C., Song, W. J., 2003, Communication & Signal Processing Lab., Division of Electronic and Computer Engineering, Pohang University Korea".

Aus "An Efficient Implementation of Forward-Backward Least-Mean-Square Adaptive Line Enhancers, Yeh, H. G., Nguyen, T. M., 1995, TDA Progress Report 42 -121" ist lediglich eine vorwärts gerichtete und rückwärts gerichtete Bestimmung eines Vorhersagefehlers zum Verbessern eines Konvergenzverhaltens in Verbindung mit einer einzelnen Vorhersagefilterung bekannt. Der Qualitätsvorteil der Abgriffjustierung (Tap Adjustment) scheint jedoch die Leistungsfähigkeit einer Einzel-Vorhersageeinrichtung zu verschlechtern, wenn die Abgriff-Aktualisierungsrate deutlich geringer als die Abgriffs/Fehler-Ansammlungsrate ist.

Aus "Block Implementation of Forward Backward Line Enhancer, Farhang-Boroujeny, B. Lim, Y. C., 1991, Quelle?", ist die Verwendung von vorwärts gerichteten und rückwärtsgerichteten Fehlerbestimmungen zum Verbessern der Konvergenz bekannt.

In "Forward-Backward LMS Adaptive Line Enhancer, Lim, Y. C. Ko, C. C., IEEE Trans, 1990, CAS-37, pp. 936 - 940" ist ein adaptiver Vorhersagealgorithmus bekannt. Dieser verwendet vorwärts gerichtete und rückwärts gerichtete Vorhersagefehler zum Aktualisieren der Koeffizientenwerte. Für einen gegebenen Rückkopplungsfaktor konvergiert der Algorithmus zu der optimalen Wiener-Lösung mit der gleichen Geschwindigkeit wie für den LMS-Algorithmus, benötigt aber die doppelte Anzahl von Multiplikationen und Additionen. Wenn jedoch die Größenordnung des Vorhersagefilters zumindest geringfügig größer als die Anzahl von sinusoiden, welche zu verbessern sind, ist, oder wenn die Frequenzen der sinusoiden Signalanteile, welche zu verbessern sind, nicht nahe 0 oder 0,5 liegen, führt dieser Algorithmus zu einer lediglich halb so großen Fehljustierung im Vergleich zu der des LMS-Algorithmus. Dabei scheint es sich somit um einen einzelnen Vorhersagefilter zu handeln, welcher vorwärts gerichtete und rückwärts gerichtete Fehler zum Verbessern des Konvergenzverhaltens verwendet. Allgemein bekannt ist ein zwei-seitiger Wiener-Filter zur Unterdrückung aus "Gupta, A. K., "On Suppression of Sinusoidal in Broadband Noise", IEEE Trans. Acoustics, Speech and Signal Processing, Vol. ASSP-33, pp. 1024 - 1026, August 1985".

Nachteilhaft bei bekannten Lösungen ist, dass die linearen Vorhersagefilter alle individuell adaptierbare, d. h. nicht abhängige Abgriffe (Taps) verwenden, wobei alle minimalphasigen oder maximalphasigen Systemen zuzuordnen sind. Alle Einzel-Vorhersagefilter (Single Predictor) weisen ein unsymmetrisches Verhalten an beiden Enden von Eingabe-Daten-Sequenzen mit einer begrenzten Länge auf. Die Tatsache, dass multiple sinusoide Signalanteile rückwärts gerichtet und vorwärts gerichtet vorhergesagt werden können, wird lediglich verwendet, um das Konvergenzverhalten zu verbessern und um eine Abgriff-Fehljustierung (Tap-Misadjustment) im konvergierten Zustand zu verbessern. Die Verwendung von vorwärts gerichteten und rückwärts gerichteten Fehlerkomponenten für'die Abgriff-Fehljustierung verbessert die Konvergenz und die Fehljustierung jedoch nicht sehr, wenn die Abgriff-Aktualisierungsrate beträchtlich geringer als die Abgriff-Fehleranhäufungsrate geteilt durch die Größenordnung bzw. Länge des Vorhersagefilters zu sein scheint. In diesem Fall geht der Abgriff-Justierungs-Qualitätsvorteil der Verwendung beider Vorhersagefehler verloren und führt zu einer Verschlechterung in dem Maß eines adaptiven einfachen Vorhersagefilters.

Die Aufgabe der Erfindung besteht darin, ein alternatives Verfahren zum Verarbeiten einer Folge aus Eingabe-Daten eines Funksystems mit einem adaptiven Filter bzw. ein solches adaptives Filter vorzuschlagen.

Diese Aufgabe wird durch ein Verfahren zum Verarbeiten einer Folge aus Eingabe-Daten eines Funksystems mit einem adaptiven Filter gemäß den Merkmalen des Patentanspruchs 1 bzw. durch ein adaptives Filter mit den Merkmalen des Patentanspruchs 11 gelöst.

Vorteilhaft ist demgemäss ein Verfahren zum Verarbeiten einer Folge aus Eingabe-Daten eines Funksystems mit einer adaptiven Filterung, wobei die Eingabe-Daten einer ersten Vorhersagefilterung zugeführt und damit gefiltert werden, die Eingabe-Daten einer zweiten Vorhersagefilterung zugeführt und damit gefiltert werden, wobei die Daten vor oder nach der zweiten Vorhersagefilterung zeitlich um eine erste Verzögerung verzögert werden und wobei die eine der ersten und der zweiten Vorhersagefilterung rückwärts gerichtet und die andere Vorhersagefilterung vorwärts gerichtet durchgeführt wird, und wobei die von der ersten und der zweiten Vorhersagefilterung gefilterten Daten zu auszugebenden Daten addiert werden.

Vorrichtungsgemäß ist demgemäß vorteilhaft ein adaptives Filter zum Verarbeiten einer Folge aus Eingabe-Daten eines Funksystems mit einem Eingang zum Eingeben der Folge aus Eingabe-Daten, einem ersten, rückwärts gerichteten Vorhersagefilter, wobei der Eingang mit dem ersten Vorhersagefilter zum Zuführen der Eingabe-Daten zum ersten Vorhersagefilter verbunden ist, einem zweiten, vorwärts gerichteten Vorhersagefilter, wobei der Eingang mit dem zweiten Vorhersagefilter zum Zuführen der Eingabe-Daten zum zweiten Vorhersagefilter verbunden ist, einer Verzögerungseinrichtung zum Verzögern der Daten vor oder hinter dem zweiten Vorhersagefilter und einer Additionseinrichtung, wobei sowohl der erste Vorhersagefilter als auch der zweite Vorhersagefilter zum Ausgeben vorhergesagter bzw. gefilterten Daten mit der diese vorhergesagten Daten addierenden Additionseinrichtung verbunden sind und die Additionseinrichtung einen Ausgang zum Ausgeben addierter Daten aufweist.

Vorteilhafte Ausgestaltungen sind Gegenstand von abhängigen Ansprüchen.

Vorteilhaft ist dabei insbesondere ein Verfahren bei dem die Eingabe-Daten mit einer zweiten Verzögerung, welche geringer als die erste Verzögerung ist, verzögert und zur Bestimmung eines Vorhersagefehlersignals verwendet werden.

Ein solches Verfahren ist besonders vorteilhaft wenn zur Bestimmung des Vorhersagefehlersignals von den Eingabe-Daten mit der zweiten Verzögerung die von der ersten Vorhersagefilterung gefilterten Daten subtrahiert werden und der ersten Vorhersagefilterung zugeführt werden und von den Eingabe-Daten mit der zweiten Verzögerung die von der zweiten Vorhersagefilterung gefilterten Daten subtrahiert werden und der zweiten Vorhersagefilterung zugeführt werden.

Alternativ ist ein solches Verfahren besonders vorteilhaft wenn zur Bestimmung des Vorhersagefehlersignals von den Eingabe-Daten mit der zweiten Verzögerung die auszugebenden Daten subtrahiert werden. Ein solches Verfahren ist besonders vorteilhaft, wenn das Vorhersagefehlersignal der ersten und der zweiten Vorhersagefilterung zugeführt wird. Ein solches Verfahren ist besonders vorteilhaft, wenn das Vorhersagefehlersignal der ersten Vorhersagefilterung zu deren adaptiver Steuerung mit Abgriffswerten zugeführt wird und der zweiten Vorhersagefilterung dazu konjugiert komplexe Abgriffswerte zu deren adaptiver Steuerung zugeführt werden. Ein solches Verfahren ist besonders vorteilhaft, wenn die Eingabe-Daten mit der zweiten Verzögerung einer indirekten Zentralabgriffssteuerung (engl.: Centertap Control) unterzogen werden, wobei der Zentralabgriffssteuerung als Steuersignal Abgriffswerte oder dazu konjugiert-komplexe Abgriffswerte der ersten Vorhersagefilterung zugeführt werden und die Ausgangswerte der Zentralabgriffssteuerung zu den von den Vorhersagefilterungen gefilterten Daten addiert werden.

Vorteilhaft ist insbesondere ein Verfahren, bei dem die Eingabe-Daten mit der zweiten Verzögerung zu den von den Vorhersagefilterungen gefilterten Daten addiert werden.

Insbesondere vorteilhaft ist ein Verfahren, bei dem die erste und/oder die zweite Verzögerung derart abgestimmt werden, dass eine Datenvorhersage mit gleicher Gruppenverzögerung von Daten über die verschiedenen Datenverarbeitungswege erzeugt und ausgegeben wird.

Insbesondere vorteilhaft ist ein Verfahren, bei dem als die Eingabe-Daten Daten eines empfangenen Signals mit multiplen sinusoiden Signalkomponenten statischer oder sich quasistatischer bzw. langsam ändernder Frequenz verwendet werden, insbesondere Eingabe-Daten eines digitalen OFDM-Fernsehsignals.

Vorteilhaft ist insbesondere ein solches Filter, bei dem die Verzögerungseinrichtung zum Verzögern der Daten derart ausgelegt ist, dass alle Komponenten, insbesondere die Vorhersagefilter eine Datenvorhersage mit gleicher Gruppenverzögerung ausgeben.

Vorteilhaft ist insbesondere ein Filter, bei dem eine weitere Verzögerungseinrichtung zum Bereitstellung eines Vorhersagefehlersignals ausgebildet und angesteuert ist.

Vorteilhaft ist insbesondere ein Filter, bei dem die weitere Verzögerungseinrichtung mit einem Eingang einer Subtraktionseinrichtung verbunden ist, deren Ausgang mit einem Steuereingang des ersten Vorhersagefilters verbunden ist, wobei ein Subtraktionseingang der Subtraktionseinrichtung mit dem Ausgang der Additionseinrichtung oder dem ersten Vorhersagefilter verbunden ist. Ein solches Filter ist besonders vorteilhaft, wenn das erste Vorhersagefilter adaptive Abgriffwerte (engl.: Taps) und das zweite Vorhersagefilter komplex-konjugierte Kopien dieser Abgriffwerte verwendet. Ein solches Filter ist besonders vorteilhaft, wenn die weitere Verzögerungseinrichtung mit einer der Subtraktionseinrichtung verbunden ist, deren Ausgang mit einem Steuereingang des zweiten Vorhersagefilters verbunden ist, wobei ein Subtraktionseingang der Subtraktionseinrichtung mit dem Ausgang der Additionseinrichtung verbunden ist.

Insbesondere vorteilhaft ist ein Filter, bei dem die weitere Vorhersageeinrichtung mit einem Eingang einer Subtraktionseinrichtung verbunden ist, deren Ausgang mit Steuereingängen des ersten und des zweiten Vorhersagefilters verbunden ist, wobei ein Subtraktionseingang der Subtraktionseinrichtung mit dem Ausgang der Additionseinrichtung verbunden ist.

Insbesondere vorteilhaft ist ein Filter, bei dem die/eine weitere Verzögerungseinrichtung ausgangsseitig mit einer gesteuerten Zentralabgriffseinrichtung (engl.: Centertap) verbunden ist, deren Ausgang mit der Additionseinrichtung zusätzlich verbunden ist. Vorteilhaft ist ein solches Filter, wenn die Zentralabgriffeinrichtung einen Steuereingang aufweist, der mit einem Steuerausgang des ersten Vorhersagefilters verbunden ist. Vorteilhaft ist ein solches Filter insbesondere auch, wenn die Zentralabgriffseinrichtung zum Durchführen reellwertiger Berechnungen ausgebildet ist.

Insbesondere vorteilhaft ist ein Filter, bei dem ein Steuereingang des zweiten Vorhersagefilters mit einem Steuerausgang des ersten Vorhersagefilters verbunden ist.

Insbesondere vorteilhaft ist ein Filter, bei dem die Komponenten so ausgebildet und angesteuert sind, dass die Filterfrequenzantwort eine lineare Phase aufweist.

Insbesondere vorteilhaft ist ein Filter, das zum Verarbeiten eines empfangenen Signals mit multiplen sinusoiden Signalkomponenten statischer oder sich quasi-statisch bzw. langsam ändernder Frequenz ausgelegt ist, insbesondere eines digitalen OFDM-Fernsehsignals.

Ausführungsbeispiele werden nachfolgend anhand der Zeichnung näher erläutert. Es zeigen:

Fig. 1 schematisch ein Schaltdiagramm eines Vorhersagefilters eines ersten Ausführungsbeispiels;

Fig. 2 ein Vorhersagefilter eines zweiten Ausführungsbeispiels;

Fig. 3 ein Vorhersagefilter eines dritten Ausführungsbeispiels;

Fig. 4 ein Vorhersagefilter eines vierten Ausführungsbeispiels;

Fig. 5 ein Vorhersagefilter eines fünften Ausführungsbeispiels;

Fig. 6 ein Vorhersagefilter eines sechsten Ausführungsbeispiels; und

Fig. 7 ein beispielhaftes Frequenzspektrum im Fall der Anwendung eines solchen adaptiven Filterverfahrens.

Die nachfolgend dargestellten Ausführungsbeispiele beziehen sich auf ein adaptives Vorhersagefilter, welches auch unter der Bezeichnung Adaptive Line Enhancer bekannt ist. Insbesondere soll für eine Folge von Eingabe-Daten x eine Kanalschätzung durchgeführt werden, wobei es sich vorzugsweise um Eingabe-Daten eines pilot-basierten OFDM-Systems handelt. Eine Verbesserung statischer Daten oder sich hinsichtlich der Frequenz langsam bzw. quasi-statisch ändernder Daten soll erzielt werden, wobei die Eingabe-Daten mit weißem Rauschen oder einem Störeinfluss benachbarter Kanäle mit einer Wirkung vergleichbar der von weißem Rauschen überlagert sind. Dabei wird eine symmetrische Anordnung aus einem ersten und einem zweiten Vorhersagefilter bevorzugt, wobei das erste Vorhersagefilter rückwärts gerichtet und das zweite Vorhersagefilter vorwärts gerichtet betrieben wird.

Beispielsweise wird die Anwendung der beschriebenen Filter verwendet, um die Kanalschätzung eines DRXD DVB-T-Empfängers (DRXD DVB-T: Debug Receive Data Digital Video Broadcasting-Television) zu verbessern. Bei den Eingabe-Daten eines solchen Empfängers handelt es sich um gewünschte Daten eines Kommunikationskanals, welche durch eine beschränkte Anzahl von Echos aufgrund verschiedener Signalpfade zwischen Sender und Empfänger verschlechtert sind, so dass dem Kommunikationskanal eine Kanalübertragungsfunktion zugeordnet ist, welche aus einer begrenzten Anzahl komplexer, mehrfach überlagerter sinusoider Signalkomponenten besteht. Wenn daher eine Messung der Kanalübertragungsfunktion als Zeitreihen durchgeführt wird, kann die Abschätzung der resultierenden Kanalübertragungsfunktion durch eine Verbesserung der begrenzten Anzahl von Spektrallinien dieser Zeitreihen signifikant verbessert werden.

Das Filter ist dabei vorzugsweise in der Lage, reell- oder komplexwertige Daten zu verbessern, welche mit weißem Rauschen überlagert sind. Die Verbesserung ist insbesondere hoch, wenn die Eingabe-Daten hohe Autokorrelationseigenschaften über eine größere zeitliche Verzögerung aufweisen, also hinsichtlich der Frequenz beschränkt oder sogar diskret sind.

Das beschriebene Filter wird durch die aufsummierten Ausgangswerte zweier Vorhersagefilter, eines ersten, rückwärts gerichteten linearen Vorhersagefilters BLP und eines zweiten, vorwärts gerichteten linearen Vorhersagefilters FLP ausgebildet, wobei beiden das Eingabe-Signal x zugeführt wird. Dem zweiten Vorhersagefilter wird das Eingabe-Signal x dabei relativ zum ersten Vorhersagefilter zeitlich verzögert zugeführt. Dem äquivalent ist eine entsprechende zeitliche Verzögerung des aus dem zweiten Vorhersagefilter ausgegebenen Wertes gemäß einer Vielzahl der nachfolgend beschriebenen Ausführungsbeispiele. Die Eingabeverzögerung in den Eingang des zweiten, vorwärts gerichteten Vorhersagefilters erfolgt so, dass die in Vorwärtsrichtung vorhergesagten Abtastwerte mit der gleichen Gruppenverzögerung ausgegeben werden, wie die rückwärts vorhergesagten Abtastwerte. Optional kann auch ein adaptiver Mittenabgriff bzw. Zentralabgriff (engl.: Centertap) bereit gestellt werden, dessen Ausgangswert ebenfalls der auszugebenden Folge von Daten y aufsummiert wird.

Zumindest eines der Vorhersagefilter weist einen Satz adaptiver Abgriffe (engl. Taps) auf. Das andere Vorhersagefilter verwendet eine komplex-konjugierte Kopie dieses Abgriffsatzes. Das gesamte resultierende Filter weist vorzugsweise einen hermitesch symmetrischen Abgriffsatz um den Zentralabgriff herum auf. Die adaptiven Abgriffe werden direkt durch einen Algorithmus gesteuert, welcher den Vorhersagefehler des Gesamtfilters minimiert. Durch einen hermitesch symmetrischen Abgriffsatz wird ein linear-phasiges Verhalten des Filters garantiert.

Mit Blick auf die Abgriffs-Anpassungskomplexität eines einzelnen linearen Vorhersagefilters ermöglicht das Gesamtfilter als adaptives Filter vorteilhafterweise eine doppelte Rauschleistungsreduzierung im Vergleich zu einem einzelnen Vorhersagefilter der gleichen Größenordnung. Außerdem ist der Berechnungsaufwand geringer als bei einem einzelnen adaptiven Vorhersagefilter der doppelten Größenordnung zum Erzielen der gleichen Leistungsfähigkeit. Außerdem erleichtert der symmetrische Abgriffssatz beider Vorhersagefilter eine effiziente Implementierung beider Vorhersagefilter in einer zusammengeführten Architektur.

Einzeln und besonders in Kombination sind daher vorteilhaft die Aspekte, dass das adaptive Filter aus einem vorteilhafterweise unter allen Umständen linear-phasigen System aufgebaut ist. Das Filter zeigt an beiden Enden von Eingabe-Datenfolgen finiter Länge ein symmetrisches Verhalten. Die Tatsache, dass multiple sinusoide Signalkomponenten vorwärts und rückwärts vorhergesagt werden können, wird vorliegend zum Verdoppeln der Anzahl von Abgriffen verwendet, um die Eingangsrauschleistung auf insbesondere die Hälfte zu reduzieren. Eine Fehljustierung von Abgriffen kann ebenfalls durch die Auswahl einer geringeren Anpassungskonstante gesteuert werden. In einem Anwendungsfall, bei dem die Anpassungsgeschwindigkeit von geringerer Bedeutung ist, kann eine stärkere Rauschreduzierung mit geringerem Rechenaufwand erzielt werden. In Fällen, in denen die Einstellungs- bzw. Justierungsrate der Abgriffe beträchtlich geringer als die Abgriffs-Fehlerkorrelations-Akkumulationsrate geteilt durch die Größenordnung bzw. Länge des Vorhersagefilters ist, wie beispielsweise bei einer DRXD-Anwendung, zeigt die Abgriffs-Aktualisierung asymptotisch ein ähnliches oder das abgesehen von einer Skalierung gleiche statistische Verhalten vergleichbar dem von FBLE/FBLMS-Algorithmen (FBLE/FBLMS: ....). Auch in dem Fall, dass die FBLE/FBLMS-Algorithmen sich hinsichtlich der Leistungsfähigkeit zu der eines einzelnen Vorhersagefilters verschlechtern, wird das vorgeschlagene symmetrische Filter weiterhin das Rauschen im Vergleich zu FBLE/FBLMS-Algorithmen halbieren, und zwar mit einem vergleichbaren Rechenaufwand.

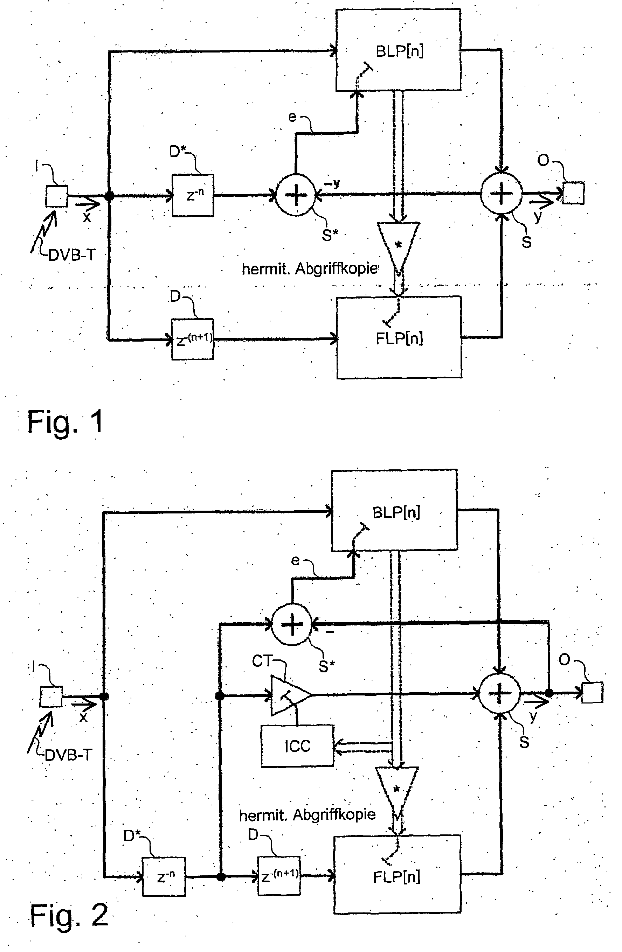

Fig. 1 zeigt ein erstes Ausführungsbeispiel eines adaptiven Filters, welches auch als ein Resonator bezeichnet werden kann. Das adaptive Filter sucht nach Filterlösungen, welche möglichst nahe an die beschriebenen Eigenschaften eines optimalen Filters heranführen. Dargestellt sind, wie auch bei den weiteren Ausführungsbeispielen, die für das Verständnis des bevorzugten Filterverfahrens hervorzuhebenden Komponenten und Verfahrensschritte. Weitere optionale oder erforderliche Komponenten sind gemäß dem üblichen Fachwissen hinzuzufügen.

Über einen Eingang I wird in das adaptive Filter eine Folge von Eingabe-Daten x eingegeben. Diese Eingabe-Daten x stammen beispielsweise von einem entfernten Sender eines digitalen terrestrischen Fernsehsystems gemäß z. B. DVB-T und wurden über eine Funkschnittstelle übertragen. Der Eingang I ist mit einem ersten, rückwärts gerichteten Vorhersagefilter BLP[n] verbunden, um diesem die Eingabe-Daten x an dessen entsprechenden Eingang anzulegen. Außerdem ist der Eingang I unter Zwischenschaltung einer Verzögerungseinrichtung D mit einem Eingang eines zweiten, vorwärts gerichteten Vorhersagefilters FLP[n] verbunden. Über diese Verbindung werden die Eingabedaten x mit einer ersten Verzögerung $z^{-(n+1)}$ zeitlich verzögert an den zweiten Vorhersagefilter FLP[n] angelegt. Die Verzögerung erfolgt dabei um n+1 Takte der Schaltungsanordnung.

Die beiden Vorhersagefilter dienen zum Vorhersagen einer gewünschten Folge aus auszugebenden Daten y, welche den ursprünglich vom Sender gesendeten Daten so weit wie möglich entsprechen sollen. Die beiden Folgen vorhergesagter Daten, welche von dem ersten bzw. dem zweiten Vorhersagefilter BLP[n], FLP[n] ausgegeben werden, werden über entsprechende Leitungen einer Additionseinrichtung S zugeführt und in dieser addiert. Der Ausgang der Additionseinrichtung S dient zugleich als Ausgang O des adaptiven Filters zum Ausgeben der vorhergesagten Folge aus Daten y. Die zeitliche Verzögerung durch die Verzögerungseinrichtung D ist dabei so gewählt, dass jeweils gleichen zu rekonstruierenden bzw. vorherzusagenden ursprünglichen Daten zugeordnete vorhergesagte Daten des ersten und des zweiten Vorhersagefilters BLP[n], FLP[n] zeitgleich bei der Additionseinrichtung S zum Addieren vorliegen.

Der Eingang I ist außerdem über eine weitere Verzögerungseinrichtung D* mit einem addierenden Eingang einer Subtraktionseinrichtung S* verbunden. Der Subtraktionseinrichtung S* werden entsprechend die Eingabe-Daten x mit einer zweiten Verzögerung $z^{-n}$ angelegt, wobei die zweite Verzögerung $z^{-n}$ eine insgesamt kürzere Verzögerung $z^{-n}$ vorsieht, als die erste Verzögerung $z^{-(n+1)}$ der ersten Verzögerungseinrichtung D. Die zweite Verzögerung $z^{-n}$ entspricht der Filterlänge n des ersten und des zweiten Vorhersagefilters BLB[n], FLP[n] gemäß dem dargestellten Ausführungsbeispiel. Einem zweiten, subtrahierenden Eingang der Subtraktionseinrichtung S* werden die von der Additionseinrichtung S addierten und auszugebenden Daten über eine entsprechende Leitung zugeführt. Von den Eingabe-Daten x mit der zweiten zeitlichen Verzögerung $z^{-n}$ werden dadurch die zeitlich entsprechenden auszugebenden Daten y subtrahiert. Der Ausgang der Subtraktionseinrichtung S* gibt ein Signal bzw. eine Folge von Daten aus, welche als Vorhersagefehlersignal e einem Steuereingang des ersten, rückwärts gerichteten Vorhersagefilters BLP[n] über eine entsprechende Leitung zugeführt werden.

Das Vorhersagefehlersignal e wird zum Ansteuern entsprechender Abgriffe des ersten Vorhersagefilters BLP[n] verwendet.

Das zweite, vorwärts gerichtete Vorhersagefilter FLP[n] verwendet zum Filtern entsprechende Abgriffe mit den zu diesen Abgriffen des ersten Vorhersagefilters konjugiert-komplexen Werten. Entsprechend wird wahlweise das Vorhersagefehlersignal e der Subtraktionseinrichtung S* dem zweiten Vorhersagefilter an einem Steuereingang von diesem zugeführt. Bevorzugt wird jedoch eine Lösung, bei welcher die konjugiert-komplexen Abtastwerte direkt von dem ersten Vorhersagefilter über eine entsprechende Verbindung zum Steuereingang des zweiten Vorhersagefilters FLP[n] geführt werden.

Hervorzuhebende Komponenten dieses ersten Ausführungsbeispiels sind somit ein erstes lineares rückwärts gerichtetes Vorhersagefilter BLP[n], eine Daten-Verzögerungseinrichtung D und ein zweites lineares Vorhersagefilter FLP[n] sowie eine Additionseinrichtung S. Alle Komponenten verarbeiten die ursprünglichen Eingabe-Daten x oder die um eine zeitliche Verzögerung $z^{-(n+1)}$ verzögerten ursprünglichen Eingabe-Daten x und sind so gesteuert, dass die von den Vorhersagefiltern ausgegebenen vorhergesagten Daten mit der gleichen Gruppenverzögerung addiert werden. Die Verzögerungskomponente wird zum Erzeugen eines Vorhersagefehlers e verwendet und kann zugleich auch den Eingang des zweiten Vorhersagefilters mit einem entsprechenden Steuersignal oder entsprechenden Werten versorgen.

Bei der Beschreibung dieses und der weiteren Ausführungsbeispiele werden einzelne bauliche Komponenten aufgeführt. Natürlich ist auch die Umsetzung in einer einzigen baulichen Komponente, beispielsweise einem integrierten Chip oder Prozessor umsetzbar. Anstelle der Verzögerungseinrichtungen können entsprechend auch Register verwendet werden, deren einzelne Datenwerte entsprechend zum Zuführen zu weiteren Komponenten abgegriffen werden.

Fig. 2 stellt ein zweites Ausführungsbeispiel mit einem optionalen Mitten- bzw. Zentralabgriff CT dar. Beschrieben werden im Wesentlichen unter Verweis auf die Ausführungen zum ersten Ausführungsbeispiel Unterschiede dazu. Die Eingabe-Daten wird zwei aufeinanderfolgend geschalteten Verzögerungseinrichtungen D*, D zugeführt, wobei die in der Reihenfolge erste der Verzögerungseinrichtungen D* der weiteren Verzögerungseinrichtung D* des ersten Ausführungsbeispiels mit einer zweiten zeitlichen Verzögerung $z^{-n}$ entspricht. Deren Ausgangswerte werden entsprechend der Subtraktionseinrichtung S* zugeführt. Außerdem werden deren Ausgangswerte der nachgeschalteten Verzögerungseinrichtung D zugeführt, welche eine zusätzliche Verzögerung $z^{-1}$ vornimmt und an deren Ausgang die Eingabe-Daten x mit der zeitlichen Verzögerung $z^{-(n+1)}$ entsprechend der ersten Verzögerungseinrichtung D des ersten Ausführungsbeispiels ausgibt und dem zweiten, vorwärts gerichteten Vorhersagefilter FLP[n] anlegt. Verwendet werden entsprechend zwei hintereinander geschaltete Verzögerungseinrichtungen D*, D mit einem zwischen diesen liegenden Abgriff anstelle zweier parallel geschalteter Verzögerungseinrichtungen D*, D. Unter den Eingabe-Daten x mit der weiteren Verzögerung sind daher, wie aus diesem Ausführungsbeispiel gut ersichtlich, Daten mit einer zeitlich geringeren Verzögerung als bei den verzögerten Daten zu verstehen, welche dem vorwärts gerichteten, zweiten Vorhersagefilter FLP[n] angelegt werden. Die Eingabe-Daten x mit der weiteren, d. h. geringeren Verzögerung $z^{-n}$ werden außerdem einem Eingang des optionalen Mitten- bzw. Zentralabgriffs CT über eine entsprechende Leitung zugeführt. Als Steuersignal werden der Einrichtung mit dem Zentralabgriff CT über eine indirekte Zentralabgriffs-Steuereinrichtung ICC ein Steuersignal bzw. entsprechende Datenwerte angelegt. Der indirekten Zentralabgriffs-Steuereinrichtung ICC wird beispielsweise direkt das Vorhersagefehlersignal e über eine entsprechende Leitung zugeführt. Bevorzugt wird jedoch das Zuführen der Abgriffwerte bzw. vorzugsweise der konjugiert-komplexen Abgriffwerte des ersten, rückwärts gerichteten Vorhersagefilters BLP[n] über eine entsprechende Leitung. Der Ausgang der Einrichtung mit dem Zentralabgriff CT ist über eine entsprechende Leitung einem weiteren Additionseingang der Additionseinrichtung S angelegt, so dass die von dem Zentralabgriff CT ausgegebenen Daten den durch die beiden Vorhersagefilter BLP[n], FLP[n] ausgegebenen und vorhergesagten Daten mit einer entsprechenden zeitlichen Verzögerung aufaddiert werden, um die insgesamt auszugebenden Daten y zu erzeugen.

Für komplexwertige Eingabesignale bzw. Eingabe-Daten werden sowohl in dem ersten als auch in dem zweiten Vorhersagefilter komplexwertige Abgriffswerte (Taps) verwendet, wohingegen der optionale Zentralabgriff vorzugsweise reellwertig angesetzt wird. Außerdem werden zumindest bei einem der linearen Vorhersagefilter adaptive Abgriffe bzw. Abgriffswerte verwendet. Das andere Vorhersagefilter verwendet komplex-konjugierte Kopien der Abgriffe des anderen Vorhersagefilters. Die Anpassung bzw. Adaption der Vorhersagefilter-Abgriffwerte wird vorzugsweise durch einen direkten Algorithmus durchgeführt. Dieser passt jeden Abgriffwert durch Minimieren des Teils des Vorhersagefehlers an, welcher durch den falsch eingestellten bzw. fehljustierten Abgriff in dem Gesamt-Resonator-Ausgangswert verursacht wurde. Vorzugsweise wird in der praktischen Umsetzung ein LMS-Algorithmus (LMS: Least Mean Square) verwendet. Jedoch können auch andere Abgriff-Anpassungsalgorithmen verwendet werden, beispielsweise gemäß RLS (R... L... S...). Optional kann zusätzlich auch der Zentralabgriff CT adaptiv angesetzt werden. Der Zentralabgriff CT bzw. die Zentralabgriffeinrichtung CT wird durch einen indirekten Adaptionsalgorithmus angepasst. Dieser indirekte Adaptionsalgorithmus basiert auf den Werten der anderen Abgriffe. Alternativ können alle Abgriffe bzw. Abgriffswerte durch einen umfangreicher ausgebildeten Algorithmus gemeinsam angepasst werden.

Konstruktiv betrachtet können die summierten Ausgangswerte beider Vorhersagefilter BLP[n], FLP[n] und der Zentralabgriffeinrichtung CT als große FIR-Filter (FIR: Finite Impulse Response) betrachtet werden, welche einen hermitesch symmetrischen Abgriffsatz um den Zentralabgriff herum aufweist. Dadurch wird sichergestellt, dass der Resonator, d. h. das adaptive Filter linear-phasige Eigenschaften aufweist. Gleichzeitig weist das adaptive Gesamt-Filter aufgrund dessen komplexwertiger Abgriffsätze eine asymmetrische Frequenz-Amplituden-Antwort um die 0-Frequenz herum auf.

Der besondere Wert dieses Resonators beim Einsatz zur Rauschreduzierung besteht nicht nur darin, dass er für alle Teile der Frequenzantwort einschließlich der unwichtigen Anteile linear hinsichtlich der Phase ist. Hervorzuheben ist, dass durch die Verkettung beider Vorhersagefilter eine doppelte Rauschleistungsreduzierung durchgeführt wird, wobei die Abgriff-Steuerkomponente die Komplexität entsprechend nur einem adaptiven Vorhersagefilter aufweist. Außerdem erleichtern die gekoppelten Abgriffsätze beider Vorhersagefilter eine hoch effiziente gemischte Implementierung beider Vorhersagefilter.

Die korrekte Arbeitsweise des Resonators kann durch viele bekannte Eigenschaften linearer Vorhersagefilter und sogenannter adaptiver Line Enhancers zum Erfassen sinusoider Signalkomponenten bestätigt werden. Für beliebige Situationen ist die optimale Wiener/Hopf-Lösung für ein rückwärts gerichtetes Vorhersagefilter BLP das hermitesch Konjugierte der optimalen Lösung des vorwärts gerichteten Vorhersagefilters FLP. Das rückwärts gerichtete Vorhersagefilter weist eine Gruppenverzögerung der Abtastwerte bzw. Datenwerte gleich der Größenordnung der Vorhersage auf, während das vorwärtsgerichtete Vorhersagefilter FLP hingegen eine Gruppenverzögerung von -1 Eingabeabtastwerten bzw. Eingabe-Datenwerten aufweist.

Durch eine korrekte Verzögerung der Eingabe-Daten x beim Zuführen zum vorwärts gerichteten Vorhersagefilter FLP[n] oder bei einem entsprechenden Verzögern von dessen vorhergesagten und ausgegebenen Daten werden sowohl eine adaptive vorwärts gerichtete als auch eine adaptive rückwärts gerichtete Vorhersagefilterung erzielt, deren vorhergesagte Daten für jeweils die gleichen Eingabe-Datenwerte die gleiche Verzögerung aufweisen.

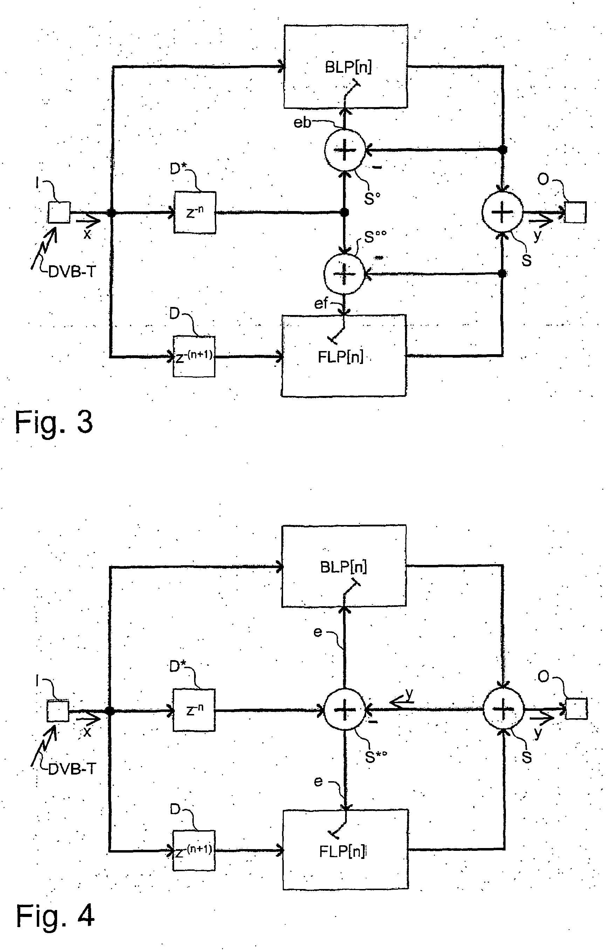

Diesbezüglich zeigt Fig. 3 ein alternatives Ausführungsbeispiel, welches insbesondere in Verbindung mit der optimalen Wiener-Lösung für beide Vorhersagefilter betrieben wird. Dabei werden zumindest Daten-Abtastwerte mit der optimalen Wiener-Lösung der Größenordnung bzw. Filterlänge L vorhergesagt. Jedoch wir das Eingangsrauschen um einen Faktor von 2 reduziert, wenn das Endergebnis mit einem einzelnen vorwärts- oder rückwärts gerichteten Vorhersagefilter verglichen wird, da 2L verschiedene Eingabe-Abtastwerte beim Erzeuge der Vorhersage anstelle von lediglich L Eingabe-Abtastwerten verwendet werden.

Fig. 3 zeigt ein Ausführungsbeispiel ähnlich dem aus Fig. 1. Der Eingang I ist wieder direkt mit dem Eingang des ersten, rückwärts gerichteten Vorhersagefilters BLP[n] verbunden. Außerdem ist der Eingang mit dem Eingang des zweiten, vorwärts gerichteten Vorhersagefilters FLP[n] über die Verzögerungseinrichtung D zum Verzögern um eine Verzögerung $z^{-(n+1)}$ verbunden. Außerdem ist der Eingang I mit einem Eingang der weiteren Verzögerungseinrichtung D* verbunden. Die Ausgänge der beiden Vohersagefilter BLP[n], FLP[n] sind wiederum mit den Eingängen der Additionseinrichtung S verbunden.

Bei diesem Ausführungsbeispiel ist der Ausgang der weiteren Verzögerungseinrichtung D* jedoch nicht mit dem Eingang von einer Subtraktionseinrichtung sondern mit den Eingängen von zwei Subtraktionseinrichtungen S°, S°° verbunden. Die subtrahierenden Eingänge der beiden Subtraktionseinrichtungen S°, S°° sind direkt mit dem Ausgang des ersten Vorhersagefilters BLP[n] bzw. im Fall der zweiten Subtraktionseinrichtung S°° mit dem Ausgang des zweiten Vorhersagefilters FLP[n] verbunden, um deren entsprechenden vorhergesagten Daten zuzuführen. Entsprechend wird ein erstes Vorhersagefehlersignal eb aus der Differenz der um die weitere Verzögerung $z^{-n}$ verzögerten Eingabe-Daten x abzüglich der entsprechenden vorhergesagten Datenwerten des ersten, rückwärts gerichteten Vorhersagefilters BLP[n] ausgebildet. Dieser erste Vorhersagefehler eb wird über eine entsprechende Leitung dem Steuereingang des ersten Vorhersagefilters BLP[n] zugeführt. Außerdem wird ein zweiter Vorhersagefehler ef durch die Differenz der um die weitere Verzögerung $z^{-n}$ verzögerten Eingabe-Daten x abzüglich der jeweils entsprechenden vorhergesagten Datenwerte des zweiten, vorwärts gerichteten Vorhersagefilters FLP[n] gebildet und entsprechend dem Steuereingang des zweiten Vorhersagefilters FLP[n] zugeführt.

Um zu zeigen, dass der Resonator bzw. das adaptive Filter auch die Ausgangswerte der optimale Wiener-Lösung für die Größenordnung 2L vorhersagt, werden die optimalen Wiener-Lösungen zum Verbessern multipler sinusoider Signalkomponenten in weißem Rauschen betrachtet. Die Theorie von adaptiven Vorhersagefiltern, insbesondere sogenannten Adaptiv Line Enhancers zeigt, dass bei ausreichend großer Größenordnung bzw. Länge L des Vorhersagefilters die optimalen BLP/FLP-Wiener-Abgrifflösungen selber auch multipel mehrfach überlagerte, aber phasenverschobene und umgekehrte Sinusoide darstellen. Wenn davon ausgegangen wird, dass die Vorhersagegrößenordnung bzw. Vorhersagelänge L des einzelnen Resonators aus den beiden derart gekoppelten Vorhersagefiltern groß genug dimensioniert ist, dann gleicht auch dessen hermitescher, gespiegelter 2L-Abgriffsatz der optimalen Wiener-Lösung mit einem 2L-Abgriffsatz.

Zum optimalen Verbessern komplexwertiger Daten muss das Filter in der Lage sein, eine asymmetrisch verteilte Amplitudenantwort um die 0-Frequenz bereit zu stellen. Auch wenn die ursprünglichen Daten durch die verbesserten Daten ausgetauscht werden, wobei diese Daten auch mit anderen Daten in einem weiteren Prozess zu kombinieren sind, sollte die verbessernde Filterfrequenzantwort hinsichtlich der Phase linear sein. In diesem Fall ist garantiert, dass alle Datenkomponenten mit gleicher Gruppenverzögerung ausgegeben werden. Daher ist die Kombination verbesserter Daten mit anderen Daten ohne das Einführen einer Phasenverzerrung möglich.

Um zu zeigen, dass dies zum Erzeugen des Fehlers aus der Gesamt-Filterausgabe gültig ist anstelle aus der Ausgabe eines einzelnen FLP-oder BLP-Vorhersagefilters, kann der Resonator mit zwei adaptiven Vorhersagefiltern konfiguriert werden, wie dies in Fig. 4 dargestellt ist. Fig. 4 zeigt einen symmetrischen, 2N-großen Vorhersagefilter ohne einen Zentralabgriff, der ebenfalls eine optimale 2N-Wiener-Lösung und doppelte Rauschunterdrückung bietet. Der Unterschied zu dem Resonator der Fig. 1 - 3 besteht darin, dass die Einstellung des zweiten, vorwärts gerichteten Vorhersagefilters FLP[n] zeitlich verschoben erfolgt. Im Vergleich zu Fig. 1 wird das Vorhersagefehlersignal e der Subtraktionseinrichtung S*° direkt den Steuereingängen sowohl des ersten, rückwärts gerichteten als auch des zweiten, vorwärts gerichteten Vorhersagefilters BLP[n], FLP[n] zugeführt. In diesem Fall liegt ein einzelnes adaptives Filter ohne einen Zentralabgriff vor, welches die sinusoiden in dem Zentralbereich innerhalb des adaptiven Filters vorhersagt. Die optimale Abgriffslösung für diesen adaptiven Line Enhancer ist die gleiche wie die einer einzeladaptiven abhängigen Konstruktion, welche einen Fehler anhand der Gesamt-Filterausgangswerte verwendet. Der Unterschied zum Resonator der übrigen Ausführungsbeispiele besteht jedoch darin, dass die Abgriffeinstellungen für den abhängigen Vorhersagefilter (Slaved-Predictor) zeitverschoben auftreten. Wenn eine Aktualisierungs-Konstante $\mu$ so herabgesetzt wird, dass individuelle Abgriff-Beiträge im Vergleich zu dem entwickelten Abgriffsatz mehr und mehr vernachlässigbar werden, bekommt auch diese Zeitverschiebung bei der abhängigen Aktualisierung einen geringeren Einfluss. Daher wird das Verhalten des Resonators gemäß der Darstellung aus Fig. 1 für geringe Aktualisierungsraten und/oder geringe Aktualisierungsfaktoren µ identisch zu dem eines doppelten adaptiven Vorhersagefilters mit Zentralwertberücksichtigung gemäß einem adaptiven Line Enhancer aus Fig. 4. Tatsächlich kann dies als ein doppelseitiges adaptive Vorhersagefilter mit einer fest verdrahteten symmetrischen Abgriff-Beschränkung interpretiert werden.

Wenn zu den einfachen Ausführungsbeispielen eine adaptive Zentral-Abgriffeinrichtung CT hinzugefügt wird, kann deren Abgriff nicht wie beispielsweise gemäß dem LMS-Ansatz durch einen direkten Abgriff-Einstellalgorithmus gesteuert werden. Jedoch besteht, wie dies in Fig. 2 dargestellt ist, die Möglichkeit einer indirekten adaptiven Verfahrensweise, welche ein stabiles adaptives Filter bereitstellt. Dies beruht darauf, dass das gesamte adaptive Filter für die einheitliche Abgriffssatz-Lösung singulär und attraktiv werden würde. Ein Filter, das die Mitte bzw. das Zentrum des Signals mittels ei-nes Einheits-Zentralabgriffs und allen anderen Abgriffen gleich 0 vorhersagen würde, würde in jedem Fall einen 0-Vorhersagefehler erzeugen, so dass eine Anpassung nicht stattfinden könnte.

Aus der optimalen Wiener-Adaptiv-Line-Enhancer-Lösung ist bekannt, dass deren optimaler Zentralabgriff die Fortführung aller der mehrfach-überlagerten sinusoiden Signalkomponenten in dem umgebenden Abgriffsatz sein muss. Daher bildet dieser die Mitte des Abgriffsatzes, wobei alle sinusoiden Signalkomponenten dort mit der Phase 0 mehrfach-überlagert sein müssen. Das heißt, der Zentralabgriff ist reellwertig und muss die Amplitudensumme aller sinusoiden Signalkomponenten aufweisen, die in dem Abgriffsatz überlagert sind.

Daher gilt, falls der optimale 2L+1-hermitesche Abgriffsatz aus N mehrfach überlagerten Sinuskurven besteht,

$$A_{i \in [-L,+L]} = \sum_{K=0..N-1} \rho_k e^{j,i,\omega_k} \ .$$

Daraus folgt der zentrale Wert

$$A_0.$$

Auch wenn das Signal-Rausch-Verhältnis hoch genug ist, so dass alle eingegebenen sinusförmigen Signalkomponenten mit einem minimalen Fehler vorherzusagen sind, wird das optimale Filter diese mit einer gleichen Amplitude in seinem Abgriffsatz mehrfach überlagern:

$$\rho_k = \frac{1}{2L+1} \Rightarrow A_0 = \frac{N}{2L+1} \ .$$

Davon ausgehend können verschiedenste Arten indirekter Verfahren verwendet werden, um diesen Wert $A_0$ nahe dieser Summen zu setzen oder zu aktualisieren. Ein möglicher Weg zum Setzen des Mittenabgriffwertes $A_0$ nahe zu diesem Wert besteht darin, das Vorhersagefilter selber zu verwenden und durch dieses den Wert des Mittenabgriffs vorherzusagen gemäß

$$A_{0neu} = \sum_{i=L..+L} A_i A_{-i} = A_{0alt}^2 + 2 \sum_{i=1...L} A_i A_i^* \ .$$

Angemerkt wird, dass eine Einheitslösung singulär verbleibt, wobei es möglich ist, die Attraktion zu der Einheitslösung hin zu verhindern, wenn das Filter in der Nähe der optimalen Lösungen für multiple sinusoide Signalkomponenten betrieben wird. Beispielsweise wird ein zufriedenstellendes Verhalten erzielt, wenn der Zentralwert $A_0$ gesetzt wird gemäß

$$A_{0neu} = \frac{2 \sum_{i=1...L} A_i A_i^*}{(1 - A_{0alt})^2 + 2 \sum_{i=1...L} A_i A_i^*} \ .$$

Die Wirkung des hinzugefügten Zentralabgriffs wird signifikant bei der Unterdrückung von Rauschen, wenn die Anzahl verschiedener sinusoider Signalkomponenten in den Eingabe-Daten, die zu verbessern sind, nahe der Größenordnung eines einzelnen vorwärts gerichteten oder rückwärts gerichteten adaptiven Vorhersagefilters FLP, BLP kommt.

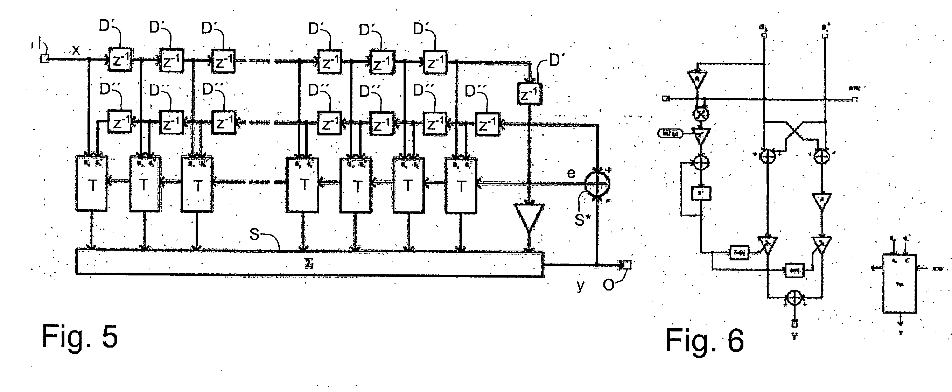

Fig. 5 zeigt ein Ausführungsbeispiel mit einer gemischten vorwärts gerichteten und rückwärts gerichteten Resonator-Architektur. Vom Eingang I aus werden die Eingabe-Daten einer in Reihe geschalteten Folge von Verzögerungseinrichtungen D' mit einer jeweiligen Verzögerung $z^{-1}$ um einen Systemtakt zugeführt. Jeweils vor und hinter jeder der Verzögerungseinrichtungen D' wird der aktuelle Datenwert abgegriffen, wobei die abgegriffenen Werte jeweils einem ersten Eingang einer Abgriff-Architektur T zugeführt wird, welche näher anhand Fig. 6 dargestellt ist. Der Ausgangswert der letzten dieser Verzögerungseinrichtungen D' wird über einen Operationsverstärker der Additionseinrichtung S zugeführt. Außerdem wird dieser Wert dem Eingang einer ebenfalls in Reihe geschalteten Folge aus einer Vielzahl weiterer Verzögerungseinrichtungen D" zugeführt. Jeweils beidseitig einer jeder dieser weiteren Verzögerungseinrichtungen D" wird wiederum ein aktueller Datenwert abgegriffen und entsprechend einem zweiten Eingang der zugeordneten Abgriffarchitekturen T in umgekehrter Reihenfolge zugeführt. Die Ausgangswerte der Abgriffarchitekturen T werden in der Additionseinrichtung S addiert. Zur Bestimmung des Vohersagefehlersignals e werden der Ausgangswert der letzten Verzögerungseinrichtung D' der ersten Gruppe von Verzögerungseinrichtungen und der Ausgangswert der Additionseinrichtung S mittels einer Subtraktionsvorrichtung S* entsprechend den vorstehend beschriebenen Ausführungsbeispielen voneinander subtrahiert. Das Vorhersagefehlersignal e wird einem jeweiligen Steuereingang der einzelnen Abgriffarchitekturen zugeführt.

Neben den dargestellten Ausführungsbeispielen besteht eine Vielzahl alternativer Realisierungsmöglichkeiten.

Verwendet werden kann beispielsweise jedes Filter, das aus einer Zusammensetzung aus einem adaptiven Filter und einem verzögerten komplex-konjugierten übertragenen abhängigen Filter besteht, wobei die Ausgangswerte von beiden mit einer gleichen Gruppenverzögerung summiert werden und eine resultierende hermitesche symmetrische Impulsantwort zentriert um die Gruppenverzögerung des Gesamtfilters aufweisen.

Das Filter kann durch eine extra Verstärkungsstufe erweitert werden, die an den Ausgang angesetzt wird. Die Ausgangsverstärkung kann verwendet werden, um das Verhalten an den beiden Endpunkten eines finiten Datensatzes zu verbessern. Um dies zu erzielen, kann eine Folge von einlaufenden und auslaufenden Verstärkungsfaktoren an dem Ausgang während des Hereinlaufens bzw. Herauslaufens des Datensatzes in den Filter programmiert werden.

Zusätzlich zu der Erweiterung um einen extra Ausgangsverstärker kann das Filter mit einem Mechanismus zum Verkleinern symmetrischer Abgriffbeiträge in der Filterausgabe erweitert werden. Auch kann hier eine extra Ausgangsstufe eine Kompensierung für den zeitweilig nicht verwendeten Abgriff vorsehen.

Sowohl die Ausgangsverstärkungsstufe als auch der Abgriff-Verkleinerungsmechanismus können in einem DRXD-Resonatorfilter realisiert werden, wobei sie den Grundgedanken um vorteilhafte Aspekte bereichern. Sie sind insbesondere aufgrund der linear-phasigen Eigenschaft des Resonators einsetzbar, da jeglicher verbleibender Resonatorfehler-Vorhersagefehler nur ein Amplitudenfehler aber kein Phasenfehler sein kann.

Unter Voraussetzung einer statischen oder quasi-statischen Umgebung, in der die sinusoiden Signalkomponenten von konstanter Frequenz sind, bietet das Filter eine sehr vorteilhafte Leistungsfähigkeit im Vergleich zu einem einzelnen linearen Vorhersagefilter. Außerdem ist es vorteilhaft hinsichtlich der Berechnungskomplexität im Vergleich zu einem einzelnen linearen Vorhersagefilter doppelter Länge mit vergleichbarer Leistungsfähigkeit.

Die symmetrische Natur des Filters bewirkt, dass das Filter ein linear-phasiges Verhalten bei idealer Betrachtung zu jedem Zeitpunkt bietet. Die symmetrische Natur des Filters ist beim Behandeln von finiten Datensätzen hilfreich, wobei das Verhalten zu Beginn des Datensatzes symmetrisch zu dem Verhalten am Ende des Datensatzes ist.

Der Einsatzbereich eines solchen adaptiven Filters bzw. Resonators ist vielfältig. Beliebige Daten oder Signale, in denen multiple sinusoide Signalkomponenten statischer oder sich langsam ändernder Frequenz enthalten sind, welche mit weißem Rauschen überlagert sind, können nicht nur erfasst, sondern signifikant und effizient durch das Filter verbessert werden. Eine signifikante Verringerung des Berechnungsaufwands wird in den Fällen möglich, in denen die Frequenzen der Sinusoiden statisch genug sind, um einen sehr geringen Abgriff-Aktualisierungsfaktor und/oder eine sehr geringe Abgriff-Aktualisierungsrate zu gerechtfertigen, welche deutlich geringer als die Abgriff-Fehler-Ansammlungsrate geteilt durch die Vorhersagegrößenordnung sind.

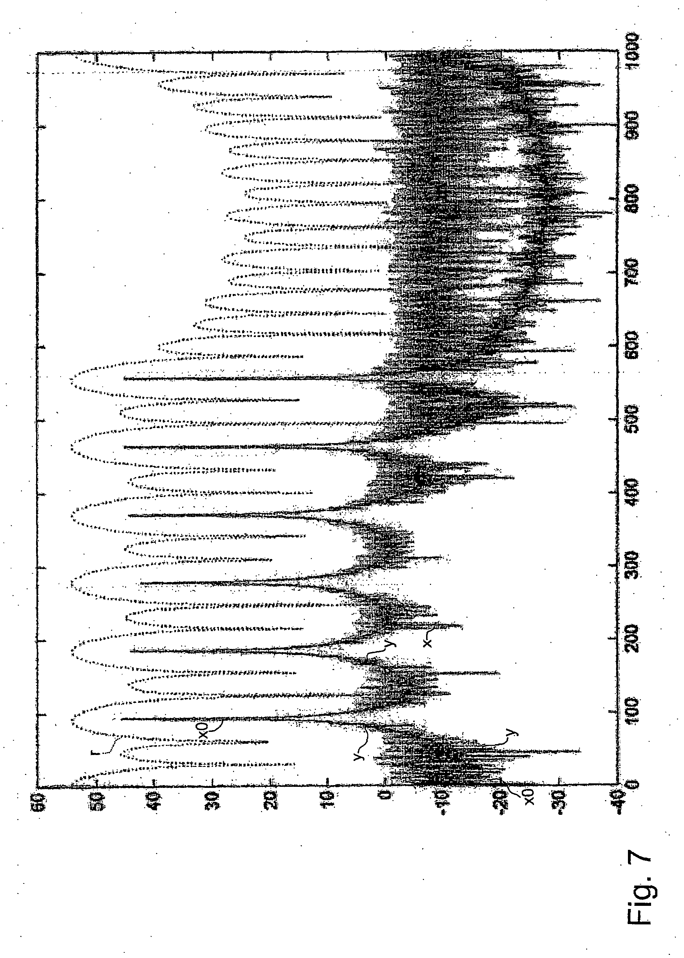

Fig. 7 zeigt beispielhaft das Eingabe- und Ausgabesignalspektrum des Filters zusammen mit der entwickelten Filterfrequenzantwort. Dargestellt ist als kontinuierlich geführte Linie x0 das Eingabesignal ohne Interferenz. Die Folge aus Eingabe-Daten x ist dem überlagert und schwingt in einem Bereich um die Kurve ohne Interferenz. Das Ergebnis der Filterung, d. h. die ausgegebenen Daten y schwingen mit dem gegenüber geringerer Amplitude um die Kurve x0, welcher keine Interferenz überlagert ist. Zusätzlich ist gepunktet die Resonatorantwort r dargestellt.

Ersichtlich ist, dass die Verbesserung multipler sinusoider Signalkomponenten durch das Unterdrücken jener Frequenzen erzielt wird, in denen nur weißes Rauschen bzw. nicht korrelierte Signalkomponenten aber keine ursprünglichen Daten mit hoher Korrelation vorliegen.

**Patentansprüche**

1. Verfahren zum Verarbeiten einer Folge aus Eingabe-Daten (x) eines Funksystems (DVB-T) mit einer adaptiven Filterung, wobei

    - die Eingabe-Daten (x) einer ersten Vorhersagefilterung (BLP[n]) zugeführt und damit gefiltert werden
    - die Eingabe-Daten (x) einer zweiten Vorhersagefilterung (FLP[n]) zugeführt und damit gefiltert werden, wobei die eine der ersten und der zweiten Vorhersagefilterung rückwärts gerichtet und die andere Vorhersagefilterung vorwärts gerichtet durchgeführt wird, und wobei die Daten vor oder nach der zweiten Vorhersagefilterung zeitlich um eine erste Verzögerung ($z^{-n+1}$) verzögert werden, und

- wobei die von der ersten und der zweiten Vorhersagefilterung (BLP[n],FLP[n]) gefilterten Daten zu auszugebenden Daten (y) addiert werden.

2. Verfahren nach Anspruch 1, bei dem die Eingabe-Daten (x) mit einer zweiten Verzögerung ($z^{-n}$), welche geringer als die erste Verzögerung ($z^{-(n+1)}$) ist, verzögert und zur Bestimmung eines Vorhersagefehlersignals (e; eb, ef) verwendet werden.

3. Verfahren nach Anspruch 2, bei dem zur Bestimmung des Vorhersagefehlersignals (eb, ef) von den Eingabe-Daten (x) mit der zweiten Verzögerung ($z^{-n}$) die von der ersten Vorhersagefilterung (BLP[n]) gefilterten Daten subtrahiert werden und der ersten Vorhersagefilterung zugeführt werden und von den Eingabe-Daten (x) mit der zweiten Verzögerung ($z^{-n}$) die von der zweiten Vorhersagefilterung gefilterten Daten subtrahiert werden und der zweiten Vorhersagefilterung zugeführt werden.

4. Verfahren nach Anspruch 2, bei dem zur Bestimmung des Vorhersagefehlersignals (e) von den Eingabe-Daten (x) mit der zweiten Verzögerung ($z^{-n}$) die auszugebenden Daten (y) subtrahiert werden.

5. Verfahren nach Anspruch 4, bei dem das Vorhersagefehlersignal (e) der ersten und der zweiten Vorhersagefilterung zugeführt wird.

6. Verfahren nach Anspruch 4 oder 5, bei dem das Vorhersagefehlersignal (e) der ersten Vorhersagefilterung (BLP[n]) zu deren adaptiver Steuerung mit Abgriffswerten zugeführt wird und der zweiten Vorhersagefilterung (FLP[n]) dazu konjugiert komplexe Abgriffswerte zu deren adaptiver Steuerung zugeführt werden.

7. Verfahren nach einem der Ansprüche 4 - 6, bei dem die Eingabe-Daten mit der zweiten Verzögerung ($z^{-n}$) einer indirekten Zentralabgriffssteuerung (CT) (engl.: Centertap Control) unterzogen werden, wobei der Zentralabgriffssteuerung als Steuersignal Abgriffswerte oder dazu konjugiert komplexe Abgriffswerte der ersten Vorhersagefilterung (BLP[n]) zugeführt werden und die Ausgangswerte der Zentralabgriffssteuerung zu den von den Vorhersagefilterungen gefilterten Daten addiert werden.

8. Verfahren nach einem der Ansprüche 2, 4, 5, oder 7, bei dem die Eingabe-Daten (x) mit der zweiten Verzögerung ($z^{-n}$) zu den von den Vorhersagefilterungen gefilterten Daten addiert werden.

9. Verfahren nach einem vorstehenden Anspruch, bei dem die erste und/oder die zweite Verzögerung ($z^{-(n+1)}$, $z^{-n}$) derart abgestimmt werden, dass eine Datenvorhersage mit gleicher Gruppenverzögerung von Daten über die verschiedenen Datenverarbeitungswege erzeugt und ausgegeben wird.

10. Verfahren nach einem vorstehenden Anspruch, bei dem als die Eingabe-Daten (x) Daten eines empfangenen Signals mit multiplen sinusoiden Signalkomponenten statischer oder sich langsam ändernder Frequenz verwendet werden, insbesondere Eingabe-Daten (x) eines digitalen OFDM-Fernsehsignals (DVB-T).

11. Adaptives Filter zum Verarbeiten einer Folge aus Eingabe-Daten (x) eines Funksystems (DVB-T) mit

- einem Eingang (I) zum Eingeben der Folge aus Eingabe-Daten (x) ,
- einem ersten, rückwärts gerichteten Vorhersagefilter (BLP[n]), wobei der Eingang (I) mit dem ersten Vorhersagefilter zum Zuführen der Eingabe-Daten zum ersten Vorhersagefilter verbunden ist,
- einem zweiten, vorwärts gerichteten Vorhersagefilter (FLP[n]), wobei der Eingang (I) mit dem zweiten Vorhersagefilter zum Zuführen der Eingabe-Daten (x) zum zweiten Vorhersagefilter verbunden ist, und
- einer Verzögerungseinrichtung (D) zum Verzögern der Daten vor oder hinter dem zweiten Vorhersagefilter und
- einer Additionseinrichtung (S),
- wobei sowohl der erste Vorhersagefilter als auch der zweite Vorhersagefilter zum Ausgeben vorhergesagter Daten (y) mit der diese vorhergesagten Daten addierenden Additionseinrichtung (S) verbunden sind und
- die Additionseinrichtung (S) einen Ausgang (O) zum Ausgeben addierter Daten (y) aufweist.

12. Filter nach Anspruch 11, bei dem die Verzögerungseinrichtung (D) zum Verzögern der Daten derart ausgelegt ist, dass alle Komponenten, insbesondere die Vorhersagefilter, eine Datenvorhersage mit gleicher Gruppenverzögerung ausgeben.

13. Filter nach Anspruch 12, bei dem die/eine weitere Verzögerungseinrichtung (D*) zum Bereitstellung eines Vorhersagefehlersignals (e; eb, ef) ausgebildet und angesteuert ist.

14. Filter nach Anspruch 12 oder 13, bei dem die weitere Verzögerungseinrichtung (D*) mit einem Eingang einer Subtraktionseinrichtung (S*, S°, S*°) verbunden ist, deren Ausgang mit einem Steuereingang des ersten Vorhersagefilters (BLP[n]) verbunden ist, wobei ein Subtraktionseingang der Subtraktionseinrichtung mit dem Ausgang der Additionseinrichtung (S) oder dem ersten Vorhersagefilter verbunden ist.

**15.** Filter nach einem der Ansprüche 11 - 14, bei dem das erste Vorhersagefilter (BLP[n]) adaptive Abgriffwerte (engl.: Taps) und das zweite Vorhersagefilter (FLP[n]) komplex-konjugierte Kopien dieser Abgriffwerte verwendet.

**16.** Filter nach einem der Ansprüche 12 - 14, bei dem die weitere Verzögerungseinrichtung (D*) mit einer/ der Subtraktionseinrichtung (S°°, S*°) verbunden ist, deren Ausgang mit einem Steuereingang des zweiten Vorhersagefilters (FLP[n]) verbunden ist, wobei ein Subtraktionseingang der Subtraktionseinrichtung mit dem Ausgang der Additionseinrichtung (S) verbunden ist.

**17.** Filter nach Anspruch 12 oder 13, bei dem die weitere Vorhersageeinrichtung (D*) mit einem Eingang einer Subtraktionseinrichtung (S*°) verbunden ist, deren Ausgang mit Steuereingängen des ersten und des zweiten Vorhersagefilters verbunden ist, wobei ein Subtraktionseingang der Subtraktionseinrichtung mit dem Ausgang der Additionseinrichtung (S) verbunden ist.

**18.** Filter nach einem der Ansprüche 12 - 14, bei dem die/eine weitere Verzögerungseinrichtung (D*) ausgangsseitig mit einer gesteuerten Zentralabgriffeinrichtung (engl.: Centertap, CT) verbunden ist, deren Ausgang mit der Additionseinrichtung (S) zusätzlich verbunden ist.

**19.** Filter nach Anspruch 18, bei dem die Zentralabgriffeinrichtung einen Steuereingang aufweist, der mit einem Steuerausgang des ersten Vorhersagefilters (BLP[n]) verbunden ist.

**20.** Filter nach Anspruch 18 oder 19, bei dem die Zentralabgriffeinrichtung zum Durchführen reellwertiger Berechnungen ausgebildet ist.

**21.** Filter nach einem der Ansprüche 11 -20, bei dem ein Steuereingang des zweiten Vorhersagefilters (FLP[n]) mit einem Steuerausgang des ersten Vorhersagefilters (BLP[n]) verbunden ist.

**22.** Filter nach einem der Ansprüche 11 - 21, bei dem die Komponenten so ausgebildet und angesteuert sind, dass die Filterfrequenzantwort eine lineare Phase aufweist.

**23.** Filter nach einem der Ansprüche 11 - 22, das zum Verarbeiten eines empfangenen Signals mit multiplen sinusoiden Signalkomponenten statischer oder sich langsam ändernder Frequenz ausgelegt ist, insbesondere eines digitalen OFDM-Fernsehsignals (DVB-T).

Fig. 1

Fig. 2

Fig. 3

Fig. 4

Fig. 5

Fig. 6

EP 1 598 935 A2

Fig. 7